Europäisches Patentamt

European Patent Office

Office européen des brevets

(11) Veröffentlichungsnummer: **0 261 482 B1**

# EUROPÄISCHE PATENTSCHRIFT

(45) Veröffentlichungstag der Patentschrift: **20.07.94**

(51) Int. Cl.5: **H03F 3/45**, H03F 3/30

(21) Anmeldenummer: **87112967.2**

(22) Anmeldetag: **04.09.87**

(54) **Operationsverstärker.**

(30) Priorität: **26.09.86 DE 3632802**

(43) Veröffentlichungstag der Anmeldung:
**30.03.88 Patentblatt 88/13**

(45) Bekanntmachung des Hinweises auf die
Patenterteilung:
**20.07.94 Patentblatt 94/29**

(84) Benannte Vertragsstaaten:
**AT BE CH DE FR GB IT LI LU NL SE**

(56) Entgegenhaltungen:
**EP-A- 0 138 261**
**EP-A- 0 228 215**
**GB-A- 2 126 817**

**IEEE JOURNAL OF SOLID-STATE CIRCUITS,
Band SC-18, Nr. 6, Dezember 1983, Seiten
652-664, IEEE, New York, US; T.C. CHOI et al.:
"High-frequenc y CMOS switched-capacitor
filters for communications application"**

**IEEE JOURNAL OF SOLID-STATE CIRCUITS,
Band SC-19, Nr. 6, Dezember 1984, Seiten
919-925, IEEE, New York, US; D.B. RIBNER et
al.: "Design techniques for cascoded CMOS
op amps with improved PSRR and common-
mode input range"**

**IEEE JOURNAL OF SOLID-STATE CIRCUITS,
Band SC-17, Nr. 6, Dezember 1982, Seiten
969-982, IEEE, New York, US; P.R. GRAY et al.:
"MOS operational amplifier design - A tutorial overview"**

(73) Patentinhaber: **SIEMENS AKTIENGESELL-
SCHAFT
Wittelsbacherplatz 2
D-80333 München(DE)**

(72) Erfinder: **Rössler, Bernward, Dipl.-Ing.
Franz-Reber-Weg 6
D-8000 München 71(DE)**
Erfinder: **Wolter, Eberhard, Dipl.-Ing.
Altomünsterstrasse 31
D-8000 München 50(DE)**

## Beschreibung

Die Erfindung betrifft einen Operationsverstärker vom "Folded-Cascode"-Typ mit Gegentaktausgängen, mit Differenz-Eingangs-Transistoren, mit diesen Transistoren jeweils nachgeschalteten, als Cascode-Stromquellen ausgeführten Lastwiderständen und mit einer durch geschaltete Kapazitäten dynamisch wirkenden Gleichtakt-Gegenkopplungsanordnung ("dynamic common-mode"-Gegenkopplung).

Integrierte Schaltkreise, in denen unter Verwendung von Operationsverstärkern eine analoge Signalverarbeitung erfolgt, weisen verbesserte Eigenschaften auf, wenn Verstärker mit symmetrischen Gegentaktausgängen verwendet werden. Derartige Verstärker bewirken gegenüber Verstärkern mit nur einem Ausgang Verbesserungen beispielsweise in bezug auf Störspannungseinkopplung, Signal-Zu-Geräusch-Verhältnis und Nichtlinearitäten geradzahliger Ordnung. Verstärker mit symmetrischen Gegentaktausgängen benötigen eine Gleichtakt-Gegenkopplung ("Common-Mode"-Gegenkopplung), die dafür sorgt, daß das mittlere Potential zwischen den Ausgängen bezogen auf eine Referenz konstant ist. Eine dynamische Gleichtakt-Gegenkopplung hat den Vorteil, daß sie den Aussteuerbereich nicht verkleinert und die Nichtlinearitäten der Verstärkungskennlinie nicht erhöht. Eine dynamische Gleichtakt-Gegenkopplung wurde bisher nur in Verstärkern angewendet, die für Signalfrequenzen im Sprachfrequenzbereich geeignet sind ("IEEE Journal of Solid-State-Circuits", Vol. SC-17, Nr. 6, Dezember 1982, Seiten 1014 bis 1023/1/;" IEEE Journal of Solid-State-Circuits", Vol. SC-20, Nr.6, Dezember 1985, Seiten 1122 bis 1132 2). Für die analoge Signalverarbeitung bei höheren Frequenzen werden einstufige Verstärker vom "Folded-Cascode"-Typ mit Gegentaktausgang verwendet ("IEEE International Solid-State Circuits Conference", 1983, Seiten 246, 247 und 314/3/; "IEEE Journal of Solid-State Circuits", Vol. SC-18, Nr.6, Dezember 1983, Seiten 652 bis 664; " IEEE Journal of Solid-State-Circuits", Vol. SC-20, Nr. 6, Dezember 1985, Seiten 1096 bis 1102/4/;" IEEE 1985 Custom Integrated Circuits Conference", Seiten 174 bis 177/5/).

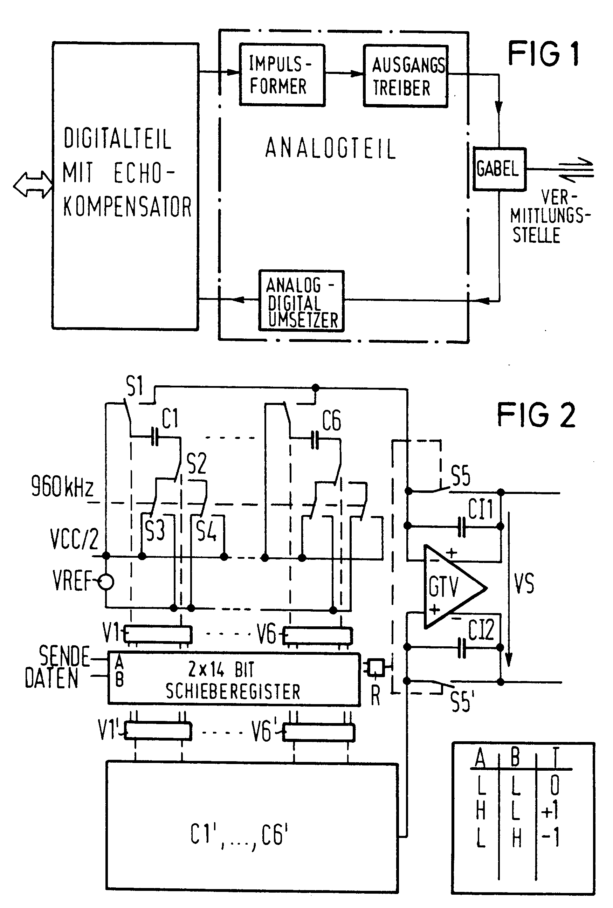

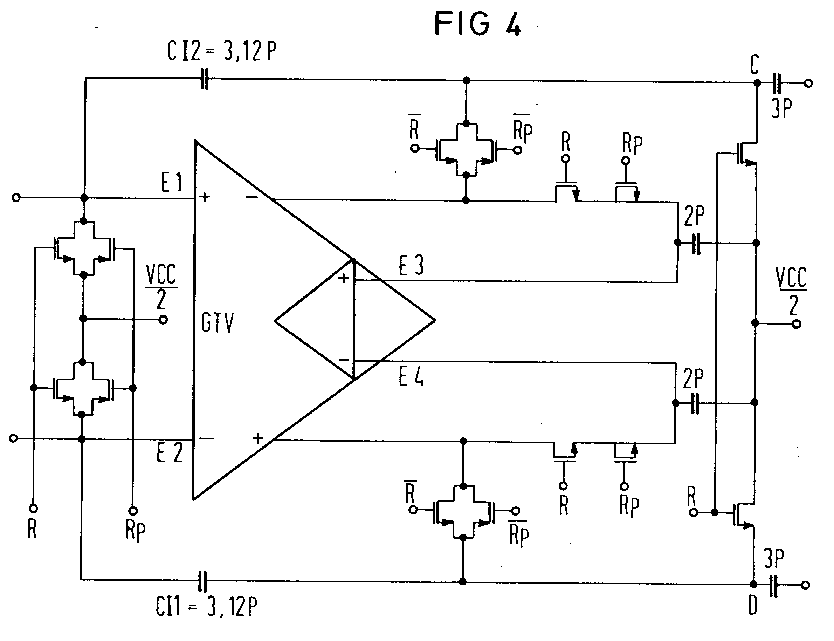

Bei den "Folded-Cascode"-Verstärkern nach / 3i / Figur 2 und /4 / Figur 2 erfolgt die statische Gleichtakt-Gegenkopplung über die Transistoren M11, M12. Diese Transistoren arbeiten im Triodengebiet und steuern den Strom durch die als Cascode-Stromquellen ausgeführten Lastwiderstände des Verstärkers durch Verändern des Source-Potentials. Der Aussteuerbereich des Verstärkers wird durch die Gleichtakt-Gegenkopplung um die Source-Drain-Spannung M11, M12 reduziert.

Bei einem aus "IEEE Journal of Solid-State Circuits", Vol. SC-19, Nr. 6, Dezember 1984, Seiten 912 bis 918, Figur 4 bekannten Verstärker erfolgt die statische Gleichtakt-Gegenkopplung durch Steuerung des Stromes durch die Eingangstransistoren M1, M2. Dafür wird ein zusätzlicher Strompfad mit den Transistoren M13 bis M20 benötigt, der den Leistungsbedarf des Verstärkers erhöht. Ein weiterer Nachteil des bekannten Verstärkers besteht darin, daß das mittlere Gleichspannungspotential der Verstärkerausgänge von den Einsatzspannungen der Transistoren M13, M14 bzw. M17, M18 abhängt. Dies bedeutet, daß der Aussteuerbereich von Herstellungsschwankungen abhängt.

Bei dem Verstärker nach / 5 /, Figur 1 erfolgt eine statische Gleichtakt-Gegenkopplung über die oberen Cascode-Stromquellen durch Veränderung des Gate-Potentials der Transistoren M4, M5. Hierzu sind zwei zusätzliche Strompfade mit den Transistoren M12 bis M19 erforderlich, die den Leistungsverbrauch des Verstärkers erhöhen. An den Aussteuergrenzen arbeiten die Transistoren M18 bzw. M19 nicht mehr in der Sättigung. Hierdurch vermindert sich der nutzbare Aussteuerbereich des Verstärkers.

Bei dem Verstärker nach /2 /, Figur 9 ist eine dynamische Gleichtakt-Gegenkopplungvorgesehen, deren drei Strompfade den Leistungsverbrauch des Verstärkers erhöhen. Infolge der Änderung des Drainstromes der Transistoren M1, M2, M4, M5 mit deren Drain-Source-Spannung wird die Verstärkung des Verstärkers reduziert.

Es ist nun Aufgabe der vorliegenden Erfindung, einen Weg zu zeigen, wie ein Operationsverstärker der eingangs genannten Art mit einem geringen schaltungstechnischen Aufwand realisiert werden kann.

Gelöst wird die vorstehend aufgezeigte Aufgabe bei einem Operationsverstärker der eingangs genannten Art erfindungsgemäß dadadurch, daß die zu den Cascode-Stromquellen gehörenden strombestimmenden Transistoren jeweils in die dynamisch wirkende Gleichtakt-Gegenkopplungsanordnung so einbezogen sind, daß die geschalteten Kapazitäten jeweils direkt mit der Steuerelektrode des entsprechenden strombestimmenden Transistors verbunden sind.

Die Erfindung bringt den Vorteil mit sich, daß durch die Ausnutzung des strombestimmenden Transistors der jeweiligen Cascode-Stromquelle zum einen als Lastwiderstand im Differenzverstärker und zum anderen als Gleichtakt-Signal-Verstärker weder zusätzliche Strompfade noch in Serie zu den Lastwiderständen geschaltete Transistoren erforderlich sind.

Vorzugsweise sind den genannten Differenz-Eingangstransistoren weitere, für eine Offsetkompensation benutzbare Differenz-Eingangstransistoren parallelgeschaltet.

Zweckmäßigerweise werden in dem Operationsverstärker Feldeffekttransistoren verwendet.

Im folgenden wird die Erfindung anhand von Zeichnungen beispielsweise näher beschrieben.

FIG 1 zeigt eine Datenübertragungseinrichtung, in welcher ein Operationsverstärker gemäß der vorliegenden Erfindung eingesetzt ist,

FIG 2 zeigt den Aufbau des in FIG 1 angegebenen Impulsformers,

FIG 3 zeigt Diagramme, auf die im Zuge der Beschreibung der Erfindung eingegangen wird,

FIG 4 zeigt die Beschaltung des in Fig.2 dargestellten Operationsverstärkers für eine Offsetkompensation und

FIG 5 zeigt den Aufbau des in Fig.2 dargestellten Operationsverstärkers.

In FIG 1 ist eine Datenübertragungseinrichtung für eine Duplexübertragung von Digitalsignalen im Gleichlageverfahren über eine Zweidraht-Leitung dargestellt. Über diese Zweidraht-Leitung möge die Datenübertragungseinrichtung beispielsweise an Übertragungseinrichtungen einer Vermittlungsstelle angeschlossen sein. Andererseits ist die Datenübertragungseinrichtung über eine Vierdraht-Leitung mit einem Datenendgerät verbunden. Die Datenübertragungseinrichtung ist dabei aus einem Digitalteil und einen Analogteil gebildet. Der Digitalteil möge dabei von dem Datenendgerät her für eine Übertragung über die Zweidraht-Leitung abgegebene Binärsignale aufnehmen und diese in dreistufige Signale umsetzen. Derartige dreistufige Signale können beispielsweise nach einem AMI-Code oder nach einem 4B-3T-Block-Code codiert sein. Nach einer solchen Codeumsetzung leitet dann der Digitalteil die umgesetzten Signale an einen zu dem Analogteil der Datenübertragungseinrichtung gehörenden Impulsformer weiter. Eine weitere Möglichkeit besteht darin, daß der Digitalteil lediglich Informationen bezüglich der zu bildenden dreistufigen Signale in binär codierter Form dem Impulsformer zuführt. Dieser Impulsformer wandelt, wie im folgenden noch erläutert werden wird, die ihm zugeführten Signale in Signale mit annähernd analogen Verlauf um und leitet diese anschließend an einen Ausgangstreiber weiter. Dieser Ausgangstreiber nimmt eine Leistungsverstärkung der von dem Impulsformer umgeformten Signale vor. Die am Ausgang dieses Ausgangstreibers auftretenden leistungsverstärkten Signale gelangen schließlich über eine Gabelschaltung als Sendesignale auf die genannte Zweidraht-Leitung.

Als Empfangssignale auf der genannten Zweidraht-Leitung auftretende Signale werden über die Gabelschaltung aufgenommen und einem Analog-Digital-Umsetzer zugeführt. Dabei gibt die Gabelschaltung zusätzlich zu den Empfangssignalen an den Analog-Digital-Umsetzer noch als Echosignale bezeichnete Störsignale ab, welche bei der Abgabe von Sendesignalen entweder direkt in der Gabelschaltung durch eine nicht vollständige Entkopplung der Übertragungswege oder an Reflektionsstellen der Zweidraht-Leitung entstehen. Damit erhält der Analog-Digital-Umsetzer nicht nur die tatsächlichen Empfangssignale sondern ein aus diesen und den Echosignalen gebildetes Signalgemisch zugeführt.

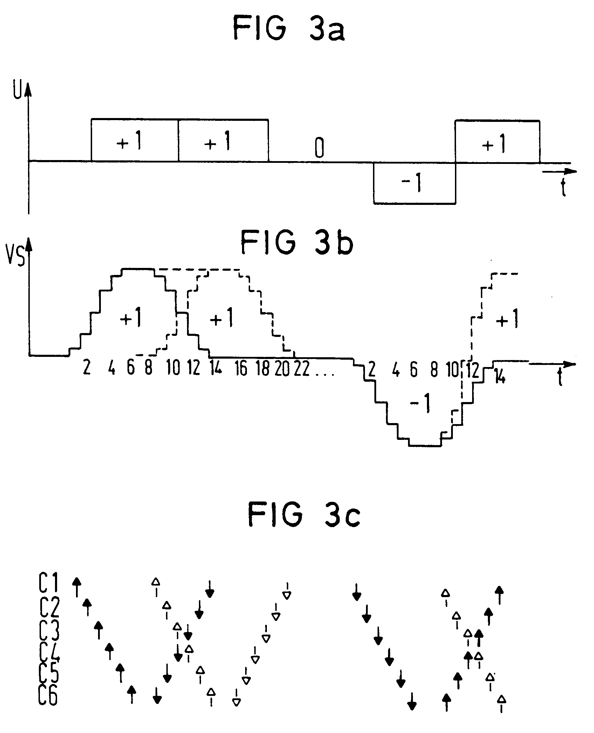

Das am Ausgang des Analog-Digital-Umsetzers in digitaler Form auftretende Signalgemisch übernimmt der Digitalteil in der in FIG 3 dargestellten Datenübertragungseinrichtung. Dieser Digitalteil weist einen Echokompensator auf, der die von dem Analog-Digital-Umsetzer in digitaler Form abgegebenen Empfangssignale von den mit diesen zusammen auftretenden Echosignalen befreit. Die von Echosignalen befreiten Empfangssignale, die wieder als dreistufige Signale auftreten, werden anschließend in dem Digitalteil in binäre Signale umcodiert und über die Vierdraht-Leitung dem genannten Datenendgerät zugeführt.

Im folgenden wird lediglich näher auf den Impulsformer der in FIG 1 dargestellten Datenübertragungseinrichtung eingegangen. Die übrigen in FIG 1 dargestellten Einrichtungen sind bereits hinlänglich bekannt, so daß sich eine Beschreibung der Wirkungsweise dieser Einrichtungen erübrigt.

Ehe auf den Aufbau des Impulsformers näher eingegangen wird, werden zunächst einige Forderungen dargelegt, die von dem Impulsformer zu erfüllen sind. Wie bereits zuvor erwähnt, mögen die von dem Endgerät abgegebenen Binärsignale für eine Übertragung über die Zweidraht-Leitung zunächst in dreistufige Signale umgesetzt werden. Derartige dreistufige Signale weisen Sendeimpulse mit einem logischen Pegel +1, 0 und -1 auf. Um im Echokompensator für +1- und -1-Sendeimpulse, abgesehen vom Vorzeichen, die gleichen Koiffizienten verwenden zu können, müssen Amplitude und Form der von dem Impulsformer umgeformten +1- und -1 Sendeimpulse möglichst genau übereinstimmen. Zur Erfüllung von Störstrahlungsanforderungen in Leitungsbündeln ist im allgemeinen für +1- und -1-Sendeimpulse eine $\sin^2$-Form vorgeschrieben. Diese $\sin^2$-förmigen Sendeimpulse sind um einen Faktor 13/8 länger als die Schrittweite der von dem Datenendgerät abgegebenen Binärsignale, so daß sich z. B. bei einer Übertragung einer Datenfolge +1, +1, -1, -1 oder +1, -1 jeweils zwei Sendeimpulse überlagern. Die Überlagerung dieser Sendeimpulse muß im Impulsformer streng linear erfolgen, damit die Echokompensation für jeden Sendeimpuls des dreistufigen Signals getrennt durchgeführt werden kann.

In FIG 2 ist der Aufbau des vorerwähnten Impulsformers näher dargestellt. Dieser Impulsformer nähert die für Sendeimpulse vorgesehene $sin^2$-Form durch einen treppenförmigen Verlauf an. Die einzelnen Sendeimpulse, die mit einer Übertragungsgeschwindigkeit von 120 kHz auftreten mögen, weisen dabei jeweils 13 960-kHz-Perioden auf. Die Impulsformung erfolgt durch Ladungsumverteilung zwischen geschalteten, in FIG 2 mit C1 bis C6 bezeichneten Umladekondensatoren und einem Summierkondensator CI1, der zwischen einem "-"-Eingang und einem "+"-Ausgang eines Gegentaktoperationsverstärkers GTV liegt. Jeder dieser Umladekondensatoren ist mit einer jeweils vier Umschalter S1 bis S4 aufweisenden Schalteranordnung verbunden.

Sämtliche Umladekondensatoren sind dabei in der gleichen Weise mit der ihnen zugehörigen Schalteranordnung verbunden. In FIG 2 ist die Anschaltung des Umladekondensators C1 an die zugehörige Schalteranordnung dargestellt. Der Umschalter S1 verbindet einen der Anschlüsse des Umladekondensators C1 wahlweise mit dem an den "-"-Eingang des Operationsverstärkers GTV angeschlossenen Anschluß des Summierkondensators CI1 oder mit einer Spannung VCC/2. Der Umschalter S2 ist an den anderen Anschluß des Umladekondensators C1 angeschlossen und steht über die Umschalter S3 und S4 wahlweise mit VCC/2 oder mit einer Bezugsspannungsquelle VREF in Verbindung. Die Umschalter S3 und S4 erhalten dabei für ihre Steuerung Taktsignale mit einer Taktfrequenz von 960 kHz zugeführt. Die beiden Umschalter S1 und S2 sind dagegen über eine Verknüpfungsschaltung V1 an festgelegte Registerzellen einer Schieberegisteranordnung angeschlossen. In entsprechender Weise sind auch die übrigen Umladekondensatoren C2 bis C6, wie für den Umladekondensator C6 angedeutet, jeweils mit der ihnen zugeordneten Schalteranordnung verbunden. Die dem Umladekondensator C6 zugeordnete Verknüpfungsschaltung ist dabei in FIG 2 mit V6 bezeichnet.

Die zuvor genannte Schieberegisteranordnung ist aus zwei 14-Bit-Schieberegistern A und B gebildet. Die dem Impulsformer mit einer Übertragungsgeschwindigkeit von 120 kHz zugeführten dreistufigen Sendesignale werden binär codiert mit einer Flanke eines 120-kHz-Taktes in die beiden Schieberegister A und B übernommen. Die für die genannte Binärcodierung maßgebende Wahrheitstabelle ist in Figur 2 dargestellt. In Spalte T sind dabei die logischen Pegel +1, 0, -1 für die dreistufigen Sendesignale dargestellt. In den Spalten A und B sind dagegen diesen logischen Pegeln entsprechende logische Pegel für die den Schieberegistern A und B zugeführten Binärsignale angegeben. Die gemäß der Wahrheitstabelle gebildeten Binärsignale durchlaufen die einzelnen Registerzellen der beiden Schieberegister mit einer Übertragungsgeschwindigkeit von 960 kHz. Die beiden Schieberegister erhalten dafür einen 960-kHz-Takt zugeführt. Mit vorgegebenen Registerzellen dieser beiden Schieberegister sind die den oben genannten Umladekondensatoren C1 und C6 zugehörigen Verknüpfungsschaltungen V1 bis V6 verbunden.

Mit den Schieberegistern A und B ist eine weitere, in Figur 2 mit R bezeichnete Verknüpfungsschaltung verbunden. Diese steuert einen Schalter S5, der auf eine entsprechende Ansteuerung hin den bereits genannten Summierkondensator CI1 kurzschließt.

Der in Figur 2 dargestellte Impulsformer weist neben den bereits genannten Umladekondensatoren C1 bis C6 weitere, nicht dargestellte Umladekondensatoren C1' bis C6' auf, die wie die Umladekondensatoren C1 bis C6 jeweils mit einer aus vier Umschaltern bestehenden Schalteranordnung verbunden sind. Diese Schalteranordnungen sind jeweils über eine Verknüpfungsschaltung, in Figur 2 mit V1' bis V6' bezeichnet, an festgelegte Registerzellen der beiden Schieberegisteranordnungen A und B angeschlossen. Die Umladekondensatoren C1' bis C6' entsprechen im übrigen den Umladekondensatoren C1 bis C6.

Darüber hinaus ist ein weiterer, über die zuletzt genannten Schalteranordnungen mit den Umladekondensatoren C1' bis C6' verbindbarer Summierkondensator CI2 vorgesehen. Dieser Summierkondensator liegt zwischen einem "+"-Eingang und einem "-"-Ausgang des bereits genannten Gegentaktoperationsverstärkers V1. Parallel zu diesem Summierkondensator ist ein Schalter S5' angeordnet. Dieser Schalter schließt den Summierkondensator CI2 auf eine Ansteuerung von der bereits genannten Verknüpfungsschaltung R hin kurz.

Im folgenden wird nun die Wirkungsweise des in Figur 2 dargestellten Impulsformers anhand der Umladekondensatoren C1 bis C6 und des Summierkondensators CI1 erläutert. Wie bereits zuvor erwähnt, erhält der Impulsformer mit einer Übertragungsgeschwindigkeit von 120 kHz auftretende dreistufige Sendeimpulse zugeführt, die gemäß der in Figur 2 dargestellten Wahrheitstabelle binär codiert sind. Abtastproben dieser binär codierten Signale werden mit Hilfe eines 120-kHz-Taktes in die beiden 14-Bit-Schieberegister A und B aufgenommen. Die einzelnen Abtastproben durchlaufen dann die Registerzellen der Schieberegister mit einer Übertragungsgeschwindigkeit von 960 kHz, so daß an den Ausgängen der Registerzellen nacheinander den Abtastproben entsprechende Signale auftreten. Durch das Auftreten dieser Signale werden 13 960-kHz-Perioden für jede Abtastprobe und damit für jeden Sendeimpuls festgelegt.

Entsprechend der genannten 13 Perioden werden die Sendeimpulse jeweils in ein 13 Perioden aufweisendes treppenförmiges Signal umgeformt.

Ein solches treppenförmiges Signal weist angenähert einen $\sin^2$-Verlauf auf. Die Impulsformung erfogt dabei durch Ladungsumverteilung zwischen den Umladekondensatoren C1 bis C6 und dem Summierkondensator CI1. Entsprechend der Richtung des Umladestromes nimmt die Ausgangsspannung VS an dem "+"-Ausgang des Gegentaktoperationsverstärkers GTV zu oder ab. Beispielsweise kann der Umladekondensator C1 auf die Bezugsspannung VREF aufgeladen werden. Die Ladung wird dann an den Summierkondensator CI1 abgegeben. Dabei tritt am Ausgang des Operationsverstärkers GTV ein Spannungssprung dVS = C1/CI1.VREF auf. Wird dagegen der Umladekondensator C1 zuerst entladen und im nächsten Schritt mit einem seiner Anschlüsse mit dem Summierkondensator CI1 und mit dem anderen Anschluß mit der Bezugsspannungsquelle VREF verbunden, dann wird der Umladekondensator C1 durch den Summierkondensator aufgeladen, wobei sich am Ausgang des Operationsverstärkers GTV ein Spannungssprung von dVS = - C1/CI1.VREF einstellt. In entsprechender Weise können auch die übrigen Umladekondensatoren Ladung an den Summierkondensator CI1 abgeben bzw. Ladung von diesem aufnehmen.

In Figur 3a ist eine von dem Impulsformer umzuformende Sendeimpulsfolge dargestellt. Als Beispiel ist eine Sendeimpulsfolge +1, +1, 0, -1, +1 angegeben. Das Diagramm 3b zeigt dagegen die dieser Sendeimpulsfolge entsprechende, am Ausgang des Operationsverstärkers GTV auftretende umgeformte Sendeimpulsfolge. Wie bereits oben erwähnt, sind die zu dieser Sendeimpulsfolge gehörenden Sendeimpulse um den Faktor 13/8 breiter als die dem Impulsformer zugeführten Sendeimpulse. Auf der Abszisse des Diagramms 3b sind dabei die zuvor genannten 960-kHz-Perioden aufgetragen, während auf der Ordinate die am Ausgang des Operationsverstärkers GTV auftretende Ausgangsspannung VS angegeben ist. In dem in Figur 3c dargestellten Pfeildiagramm ist die Reihenfolge angedeutet, in der die Umladekondensatoren C1 bis C6 bei der Sendeimpulsformung wirksam sind. Positive Spannungssprünge sind durch Pfeile nach oben und negative Spannungssprünge sind durch Pfeile nach unten symbolisch dargestellt. Die Größenverteilung der Umladekondensatoren C1 bis C6 ist durch die Anpassung der einzelnen Spannungsstufen an die $\sin^2$-Form festgelegt.

Bei der Erzeugung eines +1-Sendeimpulses wird in der ersten 960-kHz-Periode (Abtastprobe des +1-Sendeimpulses befindet sich in der ersten Registerzelle der Schieberegisteranordnung A und B) durch eine entsprechende Steuerung der mit dem Umladekondensator C1 verbundenen Schalteranordnung der Umladekondensator C1 auf VREF aufgeladen, die Ladung auf den Summierkondensator CI1 übertragen und der Umladekondensator C1 wieder freigeschaltet. Dadurch tritt am Ausgang des Operationsverstärkers GTV eine positive Veränderung der Ausgangsspannung VS auf. In der zweiten bis sechsten Periode (Abtastprobe durchläuft die Registerzellen 2 bis 6 der Schieberegisteranordnung) geschieht das gleiche mit den Umladekondensatoren C2 bis C6. In der sechsten Periode ist dann am Ausgang des Operationsverstärkers GTV der Maximalwert der Ausgangsspannung VS erreicht. Von der 9. bis 14. Periode wird der Umladekondensator C1 zunächst entladen. Anschließend wird er mit einem seiner Anschlüsse mit dem Summierkondensator CI1 und mit dem anderen Anschluß mit der Bezugsspannungsquelle VREF verbunden. Damit wird der Umladekondensator C1 durch den Summierkondensator aufgeladen, und es erfolgt nun eine negative Veränderung der Ausgangsspannung an dem Operationsverstärker GTV. In den Perioden 10 bis 14 erfolgt das gleiche für die Umladekondensatoren C2 bis C6. Damit ist in die Erzeugung eines +1-Sendeimpulses jeder Umladekondensator zweimal zeitlich nacheinander einbezogen.

Bei der Erzeugung eines -1-Sendeimpulses wird in der ersten Periode der Umladekondensator C1 entladen und von dem Summierkondensator CI1 aufgeladen. In den nächsten Perioden erfolgt das gleiche für die Umladekondensatoren C2 bis C6. Gegenüber einem +1-Sendeimpuls sind Auf- bzw. Entladung des Summierkondensators CI1 vertauscht. Da bei + 1- und - 1-Sendeimpulsen die gleiche Bezugsspannung VREF sowie die gleichen Umladekondensatoren verwendet werden, sind die Form und die Amplitude bei + 1- und - 1-Sendeimpulsen unabhängig von den Kapazitätsverhältnissen und bei einem offsetfreien Operationsverstärker GTV einander gleich.

Aus Figur 3b geht hervor, daß bei einer Sendeimpulsfolge + 1, + 1 und - 1, + 1 jeweils in der 9. bis 13. Periode eine Überlagerung erfolgt. In der 9. Periode erfolgt z.B. bei der Sendeimpulsfolge + 1, + 1 wie bei einem einzelnen Sendeimpuls eine Aufladung des Umladekondensators C6 von dem Summierkondensator CI1 her. Gleichzeitig wird aber von dem Umladekondensator C1 her Ladung auf den Summierkondensator CI1 übertragen. Da bei der Überlagerung von Sendeimpulen die gleichen Umladekondensatoren beteiligt sind wie bei einzelnen Sendeimpulsen ist die Überlagerung linear und unabhängig von Kapazitätstoleranzen.

Tritt bei einer Sendeimpulsfolge eine 0 (14. Periode bei einem einzelnen Sendeimpuls) oder ein Wechsel + 1, - 1 bzw - 1, + 1 auf, so wird der Summierkondensator zur frühestmöglichsten Periode, in der die Ausgangsspannung am Operationsverstärker GTV nominell 0 ist, kurzgeschlossen, d.h. entladen. Der Schalter S5 erhält dafür von der Verknüpfungsschaltung R ein entsprechendes Rücksetzsignal zugeführt. Durch das Entladen des Summierkondensators CI1 werden bis dahin aufgelaufene Summierungsfehler infolge einer endlichen Verstärkung oder einer Offsetspannung des Operationsverstärkers GTV beseitigt.

Vorstehend wurde anhand der in Figur 3 dargestellten Diagramme die Wirkungsweise des in Figur 2 dargestellten Impulsformers lediglich anhand der Umladekondensatoren C1 bis C6 und des Summierkondensators CI1 erläutert. In entsprechender Weise werden auch die Umladekondensatoren C1$'$ bis C6$'$ und der Summierkondensator CI2 in die Erzeugung von Sendeimpulsfolgen einbezogen. Dabei treten am "-"-Ausgang des Operationsverstärkers GTV gegenüber den Sendeimpulsen am "+"-Ausgang bezogen auf eine Referenzspannung (z.B. VCC/2) inverse Sendeimpulse auf.

Für eine Minimierung von Nichtlinearitäten der Ausgangssignale, die sich auf die Form und die Amplitude der +1- und -1-Sendeimpulse auswirken, ist einerseits der Gegentaktoperationsverstärker GTV vorgesehen. Dieser Gegentaktoperationsverstärker bewirkt eine Verminderung der Störspannungseinkopplung und eine Verbesserung des Signal/Geräuschverhältnisses. Andererseits wird durch eine Kompensationsschaltung die Offsetspannung des Operationsverstärkers GTV reduziert. Diese Offsetkompensation, die während der Rücksetzphase des Impulsformers durchgeführt wird, vermindert gleichzeitig die 1/f-Transistorrauschbeiträge im Operationsverstärker GTV. Figur 4 zeigt die für eine Offsetkompensation vorgesehene Beschaltung des Operationsverstärkers.

Der Operationsverstärker GTV weist neben den in Figur 2 dargestellten Eingängen "+" und "-", die in Figur 4 mit E1 und E2 bezeichnet sind, zwei Hilfseingänge E3, E4 auf. In der Rücksetz-Phase, d.h. bei Abgabe eines Rücksetzsignales von der in Figur 2 dargestellten Verknüpfungsschaltung R her ist der Hilfseingang E3 mit dem in Figur 2 dargestellten "-"-Ausgang des Operationsverstärkers GTV verbunden. In entsprechender Weise ist der Hilfseingang E4 in der Rücksetz-Phase mit dem "+"-Ausgang des Operationsverstärkers verbunden. Für diese Verbindungen werden jeweils zwischen den Hilfseingängen und den genannten Ausgängen des Operationsverstärkers liegende Transistoranordnungen auf das Auftreten eines Rücksetzsignals leitfähig gesteuert. Darüber hinaus ist mit den beiden Eingängen E1 und E2 des Operationsverstärkers GTV eine Reihenschaltung aus zwei Transistoranordnungen mit jeweils zwei parallelgeschalteten Transistoren verbunden. Der Verbindungspunkt zwischen den beiden Transistoranordnungen ist dabei an VCC/2 angeschlossen. Auf das Auftreten eines Rücksetzsignals hin sind die zu der Reihenschaltung gehörenden Transistoren leitfähig gesteuert, so daß in der Rücksetz-Phase und damit bei der Offsetkompensation an den beiden Eingängen E1 und E2 die gleiche Spannung anliegt.

Die beiden bereits genannten Summierkondensatoren CI1 und CI2 sind jeweils über zwei parallelgeschaltete Transistoren mit einem Ausgang des Operationsverstärkers GTV verbunden, und zwar der Summierkondensator CI1 mit dem "+"-Ausgang und der Summierkondensator CI2 mit dem "-"-Ausgang. Die parallelgeschalteten Transistoren sind dabei während der Rücksetz-Phase gesperrt, so daß die Summierkondensatoren während der Offsetkompensation von den Ausgängen des Operationsverstärkers abgetrennt sind. Gleichzeitig werden die mit den parallelgeschalteten Transistoren verbundenen Anschlüsse der Summierkondensatoren über gesonderte Transistoren mit VCC/2 verbunden. Da während dieser Zeit auch die mit den Eingängen des Operationsverstärkers verbundenen Anschlüsse der Summierkondensatoren mit VCC/2 verbunden sind, erfolgt eine Entladung der beiden Summierkondensatoren.

Durch die während der Rücksetz-Phase durchgeführte Offset-Kompensation stellt sich ein Gleichgewichtszustand ein, der einer um den Faktor VH reduzierten Offsetspannung der Eingänge E1 und E2 entspricht. Die Verstärkung VH der Hilfseingänge E3 und E4 zum Verstärkerausgang beträgt etwa VH = 100. Die Steuerspannung an den Hilfseingängen wird in zwei Kondensatoren (2P) gespeichert und ist daher auch während der Sendeimpulsformung wirksam.

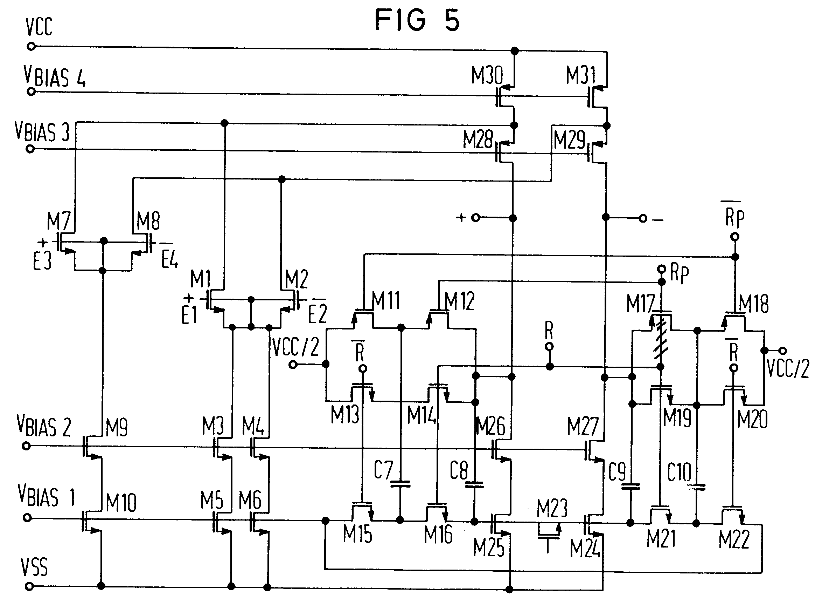

In Figur 5 ist der Aufbau des Operationsverstärkers GTV dargestellt, welcher aus Feldeffekt-Transistoren aufgebaut ist. Dieser Operationsverstärker weist zwei parallelgeschaltete Strompfade auf, die jeweils eine Reihenschaltung aus 4 Stromquellen in Form von Transistoren darstellen. Die zu den Reihenschaltungen gehörenden Transistoren sind in Figur 5 mit M25, M26, M28 und M30 bzw. M24, M27, M29 und M31 bezeichnet. Der Verbindungspunkt zwischen den Transistoren M26 und M28 bildet dabei den "+"-Ausgang und der Verbindungspunkt zwischen den Transistoren M27 und M29 den "-"-Ausgang des Operationsverstärkers GTV.

Der Operationsverstärker weist außerdem zwei parallelgeschaltete Differenz-Eingangstransistoranordnungen auf. Jede dieser Anordnungen besteht aus einer Differenz-Transistorstufe M1, M2 bzw. M7, M8, die in Reihe mit einer Stromquellenanordnung geschaltet ist. Bei der mit der Differenz-Transistorstufe M1, M2 in Reihe geschalteten Stromquellenanordnung handelt es sich um eine Parallelschaltung von jeweils zwei in Reihe geschalteten Transistoren. Die in Reihe geschalteten Transistoren sind mit M3 und M5 bzw. M4 und M6 bezeichnet. Bei der mit der Differenz-Transistorstufe M7, M8 verbundenen Stromquellenanordnung handelt es sich dagegen um eine Reihenschaltung aus den Transistoren M9 und M10.

Die Eingänge der Differenz-Transistoranordnungen stellen die Eingänge E1 und E2 sowie die Hilfseingänge E3 und E4 des Operationsverstärkers GTV dar. Dabei bildet der Eingang des Transistors M1 den Eingang E1, der Eingang des Transistors M2 den Eingang E2, der Eingang des Transistors M7 den Eingang E3 und der Eingang des Transistors M8 den Eingang E4.

Die Ausgänge der Transistoren M1 und M7 sind gemeinsam an den Verbindungspunkt zwischen den bereits genannten Transistoren M28 und M30 angeschlossen. Dagegen sind die Ausgänge der Transistoren M2 und M8 mit den Verbindungspunkt zwischen den Transistoren M29 und M31 verbunden.

Die vorstehend genannten Transistoren M1 bis M10 und M24 bis M31 bilden einen "Folded-Cascode"-Verstärker. Die Transistoren M24 bis M31 stellen dabei Lastwiderstände für die zuvor genannten Differenz-Transistoranordnungen dar.

Der in Figur 5 dargestellte Operationsverstärker weist darüber hinaus eine Gleichtakt-Gegenkopplungsanordnung auf, die aus Transistoren M11 bis M23 sowie aus den Kondensatoren C7 bis C10 gebildet ist. Über die Transistoren M11 bis M16 sowie über die Kondensatoren C7 und C8 steht dabei der Eingang des Transistors M25 mit dem " + "-Ausgang des Operationsverstärkers in Verbindung. Dagegen verbinden die Transistoren M17 bis M22 sowie die Kondensatoren C9 und C10 den Eingang des Transistors M24 mit dem "-"-Ausgang des Operationsverstärkers. Die strombestimmenden Transistoren M24 und M25 der Cascode-Stromquellen sind somit einerseits Bestandteil der Cascode-Stromquellen, die die Lastwiderstände der Differenz-Transistoranordnungen darstellen, und andererseits Bestandteil der genannten Gleichtakt-Gegenkopplungsanordnung.

Abschließend sei noch darauf hingewiesen, daß zwar der Operationsverstärker gemäß der vorliegenden Erfindung im Zusammenhang mit einem Impulsformer beschrieben worden ist. Dieser Operationsverstärker ist aber allgemein in Einrichtungen mit Gegentaktausgängen einsetzbar. Als Beispiel seien hier Signalverarbeitungsanordnungen mit geschalteten Kapazitäten und mit einer hohen Anforderung an eine geringe Störspannungseinkopplung genannt.

Bezugszeichenliste

| | | |
|---|---|---|
| A | = | Schieberegister |
| B | = | Schieberegister |
| C1,...,C6 | = | Umladekondensator |
| C1',...,C6' | = | Umladekondensator |
| C7,...,C10 | = | kondensator |
| CI1, CI2 | = | Summierkondensator |
| E1, E2 | = | Eingänge des GTV |
| E3, E4 | = | Hilfseingänge des GTV |
| GTV | = | Gegentaktoperationsverstärker |
| M1,...,M31 | = | Transistor |
| R | = | Verknüpfungsschaltung |
| S1,...,S5 | = | Schalter |
| V1,...,V6 | = | Verknüpfungsschaltung |
| V1',...,V6' | = | Verknüpfungsschaltung |
| VCC/2 | = | Referenzspannung |
| VREF | = | Bezugsspannungsquelle |
| VS | = | Ausgangsspannung des GTV |

**Patentansprüche**

1. Operationsverstärker vom "folded-cascode"-Typ mit Gegentakt-Ausgängen, mit ersten Differenz-Eingangstransistoren (M1,M2), mit diesen Transistoren jeweils nachgeschalteten, als Cascode-Stromquellen ausgeführten Lastwiderständen (M24 bis M27) und mit einer durch geschaltete Kapazitäten (C7,C8 bzw. C9, C10) dynamisch wirkenden Gleichtakt-Gegenkopplungsanordnung ("dynamic common-mode"-Gegenkopplung) (M11 bis M16, C7,C8 bzw. M17 bis M22, C9, C10) , **dadurch gekennzeichnet,** daß die zu den Cascode-Stromquellen (M24 bis M27) gehörenden strombestimmenden Transistoren (M24 und M25) jeweils in die dynamisch wirkende Gleichtakt-Gegenkopplungsanordnung so einbezogen sind daß die geschalteten Kapazitäten jeweils direkt mit der Steuerelektrode des entsprechenden strombestimmenden Transistors verbunden sind.

2. Operationsverstärker nach Anspruch 1, **dadurch gekennzeichnet,** daß den genannten ersten Differenz-Eingangstransistoren (M1, M2) zweite, für eine Offsetkompensation vorgesehene Differenz-Eingangstransistoren(M7,M8) parallelgeschaltet sind.

3. Operationsverstärker nach Anspruch 1 oder 2, **dadurch gekennzeichnet,** daß sämtliche Transistoren Feldeffekt-Transistoren sind.

4. Operationsverstärker nach Anspruch 1, **dadurch gekennzeichnet,** daß dieser Operationsverstärker den Ausgang eines Impulsformers bildet, der mehrpegelige, zu einer Eingangssignalfolge gehörende Eingangs-Digitalsignale mit sprunghaften Pegelübergängen in treppenförmige Pegelübergänge aufweisende Ausgangs-Digitalsignale umformt,

daß der Impulsformer dafür über zwei gesonderte Summiernetzwerke verfügt, die jeweils eine der Stufenanzahl eines Ausgangs-Digitalsignals entsprechende Anzahl von Teilladungen bildenden Umladekondensatoren (C1 bis C6 bzw. C1' bis C6') und einen die Teilladungen aufsummierenden Summierkondensator (CI1 bzw. CI2) aufweisen,

daß die Umladekondensatoren jeweils über eine gesonderte Schalteranordnung (S1 bis S4), die von einer mit den Eingangs-Digitalsignalen beaufschlagten Steuereinrichtung (A,B, V1 bis V6, V1' bis V6', R) her gesteuert sind, derart aktivierbar sind, daß diese jeweils nach Maßgabe der Eingangs-Digitalsignale in festgelegten Zeitintervallen eine Teilladung an den zugehörigen Summierkondensator (CI1 bzw. CI2) abgeben bzw. von diesem aufnehmen

und daß die den beiden Summiernetzwerken zugehörigen Summierkondensatoren jeweils mit einem der ersten Differenz-Eingangstransistoren (M1 bzw. M2) und einem diesem zugeordneten, durch eine der Cascode-Stromquellen (M24, M27 bzw. M25, M26) gebildeten Ausgang des Operationsverstärkers verbunden sind.

5. Operationsverstärker nach den Ansprüchen 2 und 4, **dadurch gekennzeichnet,**

daß mit dem jeweiligen Summierkondensator (CI1 bzw. CI2) eine weitere Schalteranordnung (S5 bzw. S5') verbunden ist, welche von der Steuereinrichtung (A,B, V1 bis V6, V1' bis V6', R) her derart steuerbar ist, daß die jeweilige weitere Schalteranordnung den zugehörigen Summierkondensator in festgelegten Zeitintervallen kurzschließt,

und daß in den betreffenden festgelegten Zeitintervallen für eine Offsetkompensation einerseits die genannten zweiten Differenz-Eingangstransistoren (M7 und M8) jeweils mit dem zugeordneten Ausgang des Operationsverstärkers verbunden sind und andererseits an den ersten Differenz-Eingangstransistoren (M1 und M2) eine Eingangs-Spannungsgleichheit vorliegt.

**Claims**

1. Operational amplifier of the "folded-cascode" type having push-pull outputs, comprising first differential input transistors (M1, M2), with load resistors (M24 to M27) constructed as cascode current sources and in each case following these transistors and with a dynamic colon-mode feedback arrangement (M11 to M16, C7, C8 and M17 to M22, C9, C10) by means of switched capacitors (C7, C8 and C9, C10), characterized in that the current-determining transistors (M24 and M25) belonging to the cascode current sources (M24 to M27) are in each case included in the dynamic common-mode feedback arrangement in such a manner that the switched capacitors are in each case connected directly to the control electrode of the corresponding current-determining transistor.

2. Operational amplifier according to Claim 1, characterized in that second differential input transistors (M7, M8) intended for offset compensation are connected in parallel with the said first differential input transistors (M1, M2).

3. Operational amplifier according to Claim 1 or 2, characterized in that all transistors are field-effect transistors.

4. Operational amplifier according to Claim 1, characterized in that this operational amplifier forms the output of a pulse former which converts multi-level digital input signals with abrupt level changes, belonging to an input signal sequence, into digital output signals exhibiting stairstep-like level changes, in that, for this purpose, the pulse former has two separate adding networks which in each case exhibit a number, corresponding to the number of steps of a digital output signal, of recharging capacitors (C1 to C6 and C1' to C6') forming part-charges and an adding capacitor (CI1 and CI2) adding together the part-charges, in that the recharging capacitors can in each case be activated via a separate switch arrangement (S1 to S4), which is controlled from a control device (A, B, V1 to V6, V1' to V6', R), to which the digital input signals are applied, in such a manner that these capacitors in each case emit a part-charge to the associated adding capacitor (CI1 and CI2), or receive a part charge from the latter, at predetermined time intervals as determined by the digital input signals, and in that the adding capacitors belonging to the two adding networks are in each case connected to one of the first differential input transistors (M1 and M2) and to an output, associated with this transistor and formed by one of the cascode current sources (M24, M27 and M25, M26), of the operational amplifier.

5. Operational amplifier according to Claims 2 and 4, characterized in that the respective adding capacitor (CI1 and CI2) is connected to a further switch arrangement (SK and SK') which can be controlled from the control device (A, B, V1 to V6, V1' to V6', R) in such a manner that the respective further switch arrangement short circuits the associated adding capacitor at predetermined time intervals, and in that, on the one hand, the said second differential input transistors (M7 and M8) are in each case connected to the associated output of the operational amplifier and, on the other hand, an input voltage equality exists at the first differential input transistors (M1 and M2) in the relevant predetermined time intervals for an offset compensation.

## Revendications

1. Amplificateur opérationnel du type "folded-cascode" à sorties symétriques comportant des premiers transistors (M1, M2) d'entrée de différence, ces transistors étant chacun reliés à des résistances (M24 à M27) de charge sous forme de sources de courant en cascode et un montage (M11 à M16, C7, C8 et M17 à M22, C9, C10) effectuant une contre-réaction dynamique en mode commun par des capacités d'accès (C7, C8 et C9, C10), caractérisé en ce que,
les transistors (M24 et M25), qui fixent le courant et qui font partie des sources (M24 à M27) de courant en cascode, sont chacun incorporés dans le montage effectuant une contre-réaction dynamique en mode commun, de sorte que les capacités d'accès soient reliées chacune directement à l'électrode de commande des transistors correspondant de fixation de courant.

2. Amplificateur opérationnel suivant la revendication 1, caractérisé en ce que,
des seconds transistors (M7, M8) d'entrée de différence destinés à compenser un décalage sont connectés en parallèle aux dits premiers transistors (M1, M2) d'entrée de différence.

3. Amplificateur opérationnel suivant la revendication 1 ou 2, caractérisé en ce que,
tous les transistors sont des transistors à effet de champ.

4. Amplificateur opérationnel suivant la revendication 1,
caractérisé en ce que,
cet amplificateur opérationnel forme la sortie d'un circuit de mise en forme d'impulsions, qui transforme des signaux numériques d'entrée ayant plusieurs niveaux et faisant partie d'une succession de signaux d'entrée, en signaux numériques de sortie ayant des transitions de niveaux à saut en forme d'escalier,

le circuit de mise en forme d'impulsions disposé à cet effet de deux réseaux sommateurs distincts, qui comportent chacun un nombre de condensateurs (C1 à C6 et C1' à C6') de transfert formant des charges partielles, qui correspond au nombre d'échelons d'un signal numérique de sortie et à un condensateur sommateur (CI1 et CI2) faisant la somme des charges partielles,
les condensateurs de transfert peuvent être activés par des circuits (S1 à S4) distincts, qui sont commandés par un dispositif de commande (A, B, V1 à V6, V1' à V6', R) alimenté par les signaux numériques d'entrée, l'activation s'effectuant de sorte que ceux-ci fournissent au condensateur (CI1 et CI2) sommateur correspondant ou en reçoivent une charge partielle en proportion des signaux numériques d'entrée dans des intervalles de temps fixés,
et les condensateurs sommateurs, qui font partie des deux réseaux sommateurs, sont reliés chacun à l'un des premiers transistors (M1 et M2) d'entrée de différence et à l'une des sorties de l'amplificateur opérationnel, qui est associée à ce transistor et qui est formée de l'une des sources (M24, M27 et M25, M26) de courant en cascode.

5. Amplificateur opérationnel suivant les revendications 2 et 4, caractérisé en ce que,
à chaque condensateur (CI1 et CI2) sommateur est connecté à un autre circuit (S5 et S5'), qui peut être commandé par le dispositif de commande (A, B, V1 à V6, V1' à V6', R), de sorte que cet autre circuit court-circuite le condensateur sommateur pendant des intervalles de temps fixés,
et dans les intervalles de temps fixés concernés, et pour compenser le décalage, d'une part lesdits seconds transistors d'entrée (M7 et M8) sont chacun reliés à la sortie associée de l'amplificateur opérationnel, et d'autre part une même tension d'entrée est appliquée aux dits premiers transistors (M1 et M2) d'entrée de différence.

FIG 1

FIG 2

| A | B | T |
|---|---|---|
| L | L | 0 |
| H | L | +1 |
| L | H | -1 |

## FIG 3a

## FIG 3b

## FIG 3c

FIG 4

EP 0 261 482 B1

FIG 5